# EUROPEAN PATENT APPLICATION

(11) **EP 4 701 349 A1**
(43) Date of publication of application: **25.02.2026**
(21) Application number: 24878496.9
(22) Date of filing: 03.06.2024
(51) Int. Cl.: H05K 1/02

(54) **BOARD-LEVEL STRUCTURE, DEVICE, AND ELECTRONIC APPARATUS**

(30) Priority: 18.10.2023 CN 202322802670 U
(71) Applicant: Huawei Technologies Co., Ltd., Shenzhen, Guangdong 518129 (CN)
(72) Inventor: LIU, Zhitao, Shenzhen, Guangdong 518129 (CN); HAN, Lei, Shenzhen, Guangdong 518129 (CN)
(74) Representative: Pfenning, Meinig & Partner mbB
(86) International application number: PCT/CN2024/096961
(87) International publication number: WO 2025/081843

(57) **Abstract**

This application provides a board-level structure, a component, and an electronic device. The board-level structure includes a second substrate and at least one first component. The first component includes a first body and a first substrate, a first solder joint and a second solder joint are disposed on the first substrate, and the first substrate is connected to the first body through the first solder joint. An accommodation portion and a third solder joint are disposed on the second substrate, the third solder joint is located on the second substrate and is close to the accommodation portion, the first substrate is soldered to the second substrate through the second solder joint and the third solder joint, the first substrate is bridged above the accommodation portion, and at least a part of the first body extends into the accommodation portion. In this application, the accommodation portion can offset a part of a Z-direction height of the first body, to reduce space occupation. The first substrate may be directly soldered to the second substrate through the second solder joint and the third solder joint. Therefore, a pad needs to be formed on a surface of the second substrate in only one process flow to connect to the first substrate, thereby simplifying an assembly process and ensuring assembly quality.

## Description

The present invention claims priority to Chinese Patent Application No. 202322802670.2, filed with the China National Intellectual Property Administration on October 18, 2023 and entitled "BOARD-LEVEL STRUCTURE, COMPONENT, AND ELECTRONIC DEVICE", which is incorporated herein by reference in its entirety.

### TECHNICAL FIELD

This application relates to the field of electronic product technologies, and specifically, to a board-level structure, a component, and an electronic device.

### BACKGROUND

In an electronic product, various components are integrated on a circuit board to implement different functions. A bottom of the component usually needs to be soldered to the circuit board. Usually, for a component with a large height, a slot is provided in the circuit board, and the component with the large height is directly soldered to a bottom surface of the slot, to offset a part of the height of the component using a depth of the slot, thereby reducing occupation of external space of the circuit board by the component with the large height. However, soldering of the component in the slot is limited by a process, and the component cannot be soldered together with another component disposed on a surface of the circuit board, and can only be soldered separately. The process is complex.

### SUMMARY

In view of this, this application provides a board-level structure, a component, and an electronic device, to reduce occupation of external space of a circuit board by a component with a large height, and simplify a mounting process of the component.

According to a first aspect, an embodiment of this application provides a board-level structure, including a second substrate and at least one first component. The first component includes a first body and a first substrate, a first solder joint and a second solder joint are disposed on the first substrate, and the first substrate is connected to the first body through the first solder joint. The second substrate includes an accommodation portion and a third solder joint, and the third solder joint is located on the second substrate and is close to the accommodation portion. The first substrate is soldered to the second substrate through the second solder joint and the third solder joint, the first substrate is bridged above the accommodation portion, and at least a part of the first body extends into the accommodation portion. "Above" refers to a position that is on an outer side of the second substrate and that can be opposite to the accommodation portion. For example, the first substrate may be connected to a surface of the second substrate, and an edge of the first substrate can be lapped over the second substrate around the accommodation portion, without extending into the accommodation portion.

In this application, the accommodation portion in the second substrate can offset a part of a Z-direction height of the first body, to reduce occupation of Z-direction space of the outer side of the second substrate by the first body, thereby facilitating a thin design of an electronic device. In addition, the accommodation portion is only configured to accommodate the first body, and is not configured to solder the first body. Therefore, there is no need to separately dispose a pad in the accommodation portion, and the first substrate may be directly soldered to the second substrate through the second solder joint and the third solder joint. Therefore, a solder joint needs to be formed on a surface of the second substrate in only one process flow to connect to the first substrate. In this way, an assembly process can be greatly simplified, and assembly quality can be ensured.

In a possible implementation, the accommodation portion is a through slot, and the through slot penetrates the second substrate in a thickness direction of the board-level structure. When a height of the first body is greater than or equal to a thickness of the second substrate, a height value of the first body offset by the through slot is equal to the thickness of the second substrate, so that the height of the first body offset by the second substrate can be maximized. In addition, a design in which the accommodation portion is a through slot makes it impossible to dispose a solder joint at a bottom of the through slot in the conventional technology to solder the first body.

In a possible implementation, there is a gap between an inner wall of the accommodation portion and the first body. The gap exists between the inner wall of the accommodation portion and the first body, so that a mounting tolerance of the first body can be offset by the gap. This ensures that the first body can be normally mounted in the accommodation portion without interference or friction against the inner wall of the accommodation portion, to avoid mounting failure and surface wear-out of the first body. In addition, vibration and heat from the second substrate cannot be directly transferred to the first body, thereby reducing impact of the vibration and heat on the first body.

In a possible implementation, the second substrate has a first surface and a second surface on two sides in the thickness direction. The board-level structure further includes at least one second component, and the second component is connected to the first surface and/or the second surface. The first substrate is connected to the first surface and/or the second surface. Therefore, assembly between the first component, the second component, and the second substrate provided in embodiments of this application is flexible, and may be specifically arranged according to an actual mounting condition.

In a possible implementation, the first substrate is connected to the first surface, at least a part of the second component is connected to the second surface, and in the thickness direction of the board-level structure, a height of the first body is less than or equal to a sum of a thickness of the second substrate and a height of the second component. For example, the accommodation portion is a through slot, and when a height of the first body is greater than a thickness of the second substrate and less than a sum of the thickness of the second substrate and a height of the second component, the first body is inserted into the through slot from a side of the first surface of the second substrate, and can penetrate from the through slot from a side of the second surface of the second substrate. Because the height of the first body is less than or equal to the sum of the thickness of the second substrate and the height of the second component, a part of the first body that penetrates from the through slot does not protrude from an end of the second component connected to the second surface. Therefore, the second substrate and the second component can offset the overall height of the first body together. In this way, additional Z-direction space cannot be occupied by the first body.

In a possible implementation, both the first substrate and the second component are connected to the first surface or the second surface, and in the thickness direction of the board-level structure, a height of the first body is less than or equal to a thickness of the second substrate. For example, the accommodation portion is a through slot, both the first substrate and the second component are connected to the first surface, and the second component is not disposed on the second surface. When the height of the first body is less than or equal to the thickness of the second substrate, the thickness of the second substrate may completely offset the height of the first body, and one end of the first body away from the first substrate does not extend from a side of the second surface of the second substrate. In this way, additional Z-direction space cannot be occupied by the first body.

In addition, a design in which the accommodation portion is a through slot makes it impossible to dispose a solder joint at a bottom of the through slot in the conventional technology to solder the first body.

In a possible implementation, the accommodation portion is a blind slot.

In a possible implementation, a ratio of a thickness of a bottom of the blind slot to a thickness of the second substrate is less than 3/10. A physical material at the bottom of the blind slot has no strength requirement, and a thickness of the physical material may be a smaller value than that in the conventional technology, so that space of the blind slot can be further expanded, to offset more of the height of the first body.

In a possible implementation, a thickness value of the second substrate ranges from 0.5 mm to 1.0 mm, and a thickness of a bottom of the blind slot is less than 0.3 mm. A thickness value of the second substrate may be 0.5 mm, 0.6 mm, 1.0 mm, or the like. Correspondingly, if the bottom of the blind slot needs to support a component, the thickness of the bottom of the blind slot needs to be greater than 0.3 mm to ensure support strength. However, in this embodiment, the first body does not need support from the bottom of the blind slot, and the thickness of the bottom of the blind slot may be further reduced to a range less than 0.3 mm, so that space of the blind slot may be further expanded, to offset more of the height of the first body.

In a possible implementation, the second substrate is a printed circuit board.

According to a second aspect, an embodiment of this application further provides a first component, including a first substrate and a first body. The first substrate includes a first surface and a second surface that are disposed opposite to each other, a first solder joint and a second solder joint are disposed on the first surface, the first substrate is connected to the first body through the first solder joint, and the second solder joint is configured to connect to a second substrate. An accommodation portion is disposed in the second substrate, and at least a part of the first body extends into the accommodation portion.

The first component used in the foregoing board-level structure has a technical effect similar to that of the foregoing board-level structure, and details are not described herein again.

In a possible implementation, a plurality of first bodies are disposed, and all the plurality of first bodies are connected to the first substrate. The plurality of first bodies may implement a same function, or may implement different functions. The plurality of first bodies are connected to one first substrate, so that the first component can be assembled to the second substrate as a whole.

In a possible implementation, the first component further includes a second body, and the second body is disposed on the second surface. The first body and the second body are respectively connected to two opposite sides of the first substrate. The first substrate provides more positions for connections of bodies that can implement different functions, so that more functional components are disposed on the second substrate, thereby improving integration, saving space, and facilitating miniaturization of an electronic device.

In a possible implementation, in a thickness direction of the board-level structure, a height of the second body is less than a height of the first body. The first body with the larger height is disposed on a side that is of the first substrate and that faces the second substrate, and the height of the first body may be offset by the accommodation portion of the second substrate, thereby reducing occupation of space outside the second substrate. The second body with the smaller height is disposed on a side that is of the first substrate and that is away from the second substrate, to form a mounting form of "face-up mounting". The height of the second body is equivalent to a height of a component like another second component, so that space above the first substrate can be fully used, and an overall height of the board-level structure is not limited.

In a possible implementation, the first component further includes a package, and the package encapsulates the first body. After the first body is soldered to the first substrate through the first solder joint, the package may fixedly encapsulate a surface of the first component, and the first solder joint may also be encapsulated by the package, so that the first body and the first solder joint can be protected, and impurities and water vapor in an environment cannot erode the first body and the first solder joint.

In a possible implementation, the first substrate is a printed circuit board.

According to a third aspect, an embodiment of this application further provides an electronic device, including the board-level structure provided in the first aspect of this application. The electronic device including the foregoing board-level structure has a technical effect similar to that of the foregoing board-level structure, and details are not described herein again.

It should be understood that the foregoing general descriptions and the following detailed descriptions are merely used as an example, and should not limit this application.

### BRIEF DESCRIPTION OF DRAWINGS

To describe technical solutions in embodiments of this application more clearly, the following briefly describes the accompanying drawings for embodiments. It is clear that the accompanying drawings in the following descriptions show merely some embodiments of this application, and a person of ordinary skill in the art may derive other drawings from these accompanying drawings without creative efforts.
FIG. 1 is a diagram of a structure of a first component according to an embodiment of this application;
FIG. 2 is a diagram of a board-level structure according to Embodiment 1 of this application;
FIG. 3 is a diagram of a structure of an electronic device according to an embodiment of this application;
FIG. 4 is a diagram of a board-level structure according to Embodiment 2 of this application;
FIG. 5 is a diagram of a board-level structure according to Embodiment 3 of this application;
FIG. 6 is a diagram of a board-level structure according to Embodiment 4 of this application;
FIG. 7 is a diagram of a structure of a first component according to another embodiment of this application;
FIG. 8 is a diagram of a board-level structure according to Embodiment 5 of this application;
FIG. 9 is a diagram of a board-level structure according to Embodiment 6 of this application;
FIG. 10 is a diagram of a structure of a first component according to still another embodiment of this application; and
FIG. 11 is a diagram of a structure of a first component according to yet another embodiment of this application.

Reference numerals:
- 1:: first component;
11: first substrate;
111: first surface;
112: second surface;
12: first body;
13: first solder joint;
14: second solder joint;
15: second body;
- 2:: second substrate;
21: accommodation portion;
22: physical material;
23: first surface;
24: second surface;
- 3:: second component;
- 4:: package;
- Z:: thickness direction.

### DESCRIPTION OF EMBODIMENTS

To better understand technical solutions of this application, the following describes embodiments of this application in detail with reference to the accompanying drawings.

It should be noted that described embodiments are merely some rather than all of embodiments of this application. All other embodiments obtained by a person of ordinary skill in the art based on embodiments of this application without creative efforts shall fall within the protection scope of this application.

The terms used in embodiments of this application are merely for the purpose of describing specific embodiments, and are not intended to limit this application. The terms "a", "said" and "the" of singular forms used in embodiments and the appended claims of this application are also intended to include plural forms, unless otherwise specified in the context clearly.

It should be understood that the term "and/or" used in this specification describes only an association relationship between associated objects and represents that three relationships may exist. For example, A and/or B may represent the following three cases: Only A exists, both A and B exist, and only B exists. In addition, the character "/" in this specification generally indicates an "or" relationship between the associated objects.

In descriptions of this application, unless otherwise specified and limited, the terms "first" and "second" are merely intended for a purpose of description, and cannot be understood as an indication or implication of relative importance. Unless otherwise specified or stated, the term "a plurality of" means two or more than two. The terms "connection", "fastening", and the like all should be understood in a broad sense. For example, "connection" may be a fastened connection, or may be a detachable connection, an integrated connection, or an electrical connection; or may be a direct connection, or may be an indirect connection through an intermediate medium. A person of ordinary skill in the art may understand specific meanings of the foregoing terms in this application based on a specific case.

Various components are integrated on a circuit board in an electronic device like a mobile phone or a computer to implement different functions. These components are usually soldered on a same plane of the circuit board, and heights of the components vary in a thickness direction of the electronic device. One or more components with a large height on the circuit board affect occupation of Z-direction space (space in the thickness direction of the electronic device) in the electronic device, and further affect a thickness of the electronic device. For example, on a same circuit board, a height difference is formed between a component with a largest height and another component with a small height, and space within a range of the height difference usually cannot be used. In addition, due to a limitation of the component with the largest height, space cannot be further compressed in a Z direction. Consequently, a thickness of an electronic device is large, which is not conducive to implementing a thin design of the electronic device.

To reduce occupation of Z-direction space in the electronic device by the component, a blind slot is usually disposed in the circuit board, and a component with a large height is soldered to a bottom of the blind slot, to offset a part of the height of the component using the blind slot. However, disposing a pad in the blind slot is limited by a technical process. For example, a stencil printing process is usually used to print a pad on a surface of a circuit board, that is, a specified gap is maintained between a stencil and the surface of the circuit board, and a pad with a preset thickness may be formed via the gap. However, at a position of the blind slot, a distance between a bottom surface of the blind slot and the stencil is large. Consequently, the blind slot is filled with tin, and an effective pad cannot be formed. As a result, a component cannot be mounted. In this case, the pad in the blind slot needs to be processed by using a dedicated process. In other words, the pad on the surface of the circuit board and the pad in the blind slot need to be implemented by using at least two processes. The processes are complex, and prone to defects such as an adhesive residue and a foreign matter impurity on the pad processed in the blind slot.

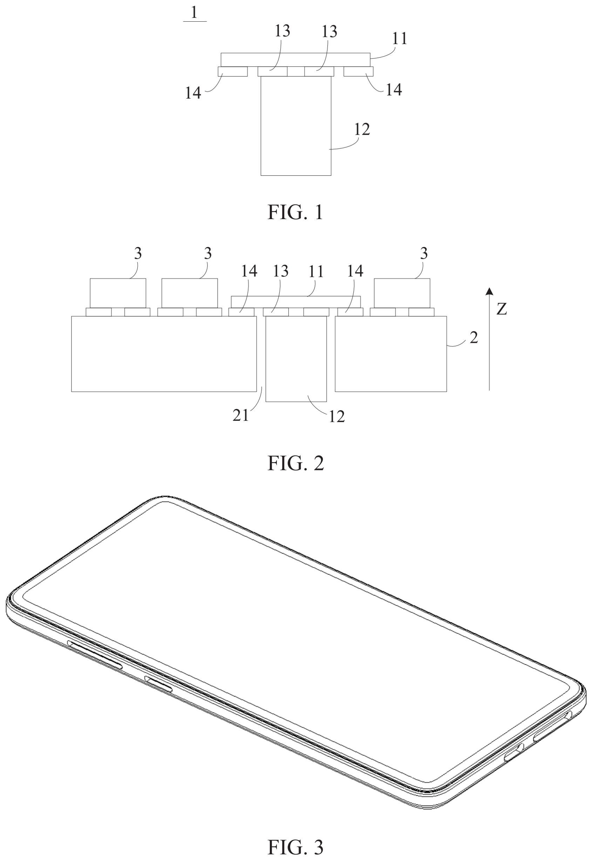

FIG. 1 is a diagram of a structure of a first component 1 according to an embodiment of this application. FIG. 2 is a diagram of a structure of a board-level structure according to Embodiment 1 of this application. As shown in FIG. 1, an embodiment of this application provides the first component 1. The first component 1 may be configured to be assembled into a board-level structure (as shown in FIG. 2). The board-level structure may be used in an electronic device, to implement various different functions in the electronic device. The electronic device may be a mobile phone, a tablet computer, a notebook computer, a smart home, a smart band, a smart watch, a smart helmet, smart glasses, a vehicle-mounted device, a smart city device, or the like. A specific type of the electronic device is not limited in embodiments of this application. FIG. 3 is a diagram of a structure of an electronic device according to an embodiment of this application. FIG. 3 merely shows an example in which the electronic device is a mobile phone. In embodiments of this application, an example in which the electronic device is a mobile phone is used for description.

Refer to FIG. 1. The first component 1 includes a first substrate 11 and at least one first body 12. The first body 12 may be an inductor, a capacitor, or a chip component, and certainly may also be other components. These components may have pins, or may not have pins, and may be soldered on the hard first substrate 11. The first substrate 11 may be a printed circuit board (Printed Circuit Board, PCB). In some embodiments, the printed circuit board PCB may be a flame-retardant material (FR-4) dielectric board, or may be a Rogers (Rogers) dielectric board, or may be a hybrid dielectric board of Rogers and FR-4, or the like. Herein, FR-4 is a grade designation of a flame-retardant material, and the Rogers dielectric board is a high-frequency board. In some embodiments, a second substrate 2 and the first substrate 11 may alternatively be made of other board materials, for example, silicon substrates. The first substrate 11 is made of a hard material, and can be stably soldered and fastened to the second substrate.

Refer to FIG. 1 and FIG. 2. The first substrate 11 includes a first surface 111 and a second surface 112 that are disposed opposite to each other. A first solder joint 13 and a second solder joint 14 are disposed on the first surface 111. The first substrate 11 is connected to the first body 12 through the first solder joint 13. A third solder joint is disposed on the second substrate 2. The first substrate 11 is soldered to the second substrate 2 through the second solder joint 14 and the third solder joint (not shown in the figure). The second substrate 2 and the first substrate 11 may be made of a same board material. Details are not described herein again. The second substrate 2 is configured for mounting of various components, and a tracing layer is disposed on the second substrate 2, so that electrical connections between the various components can be implemented. After the second substrate 2 and the first component 1 are assembled, a board-level structure may be formed, and the board-level structure can be mounted in an electronic device as a whole. In an embodiment, one or more first components 1 may be disposed in the board-level structure, and a specific quantity may be arranged according to an actual condition.

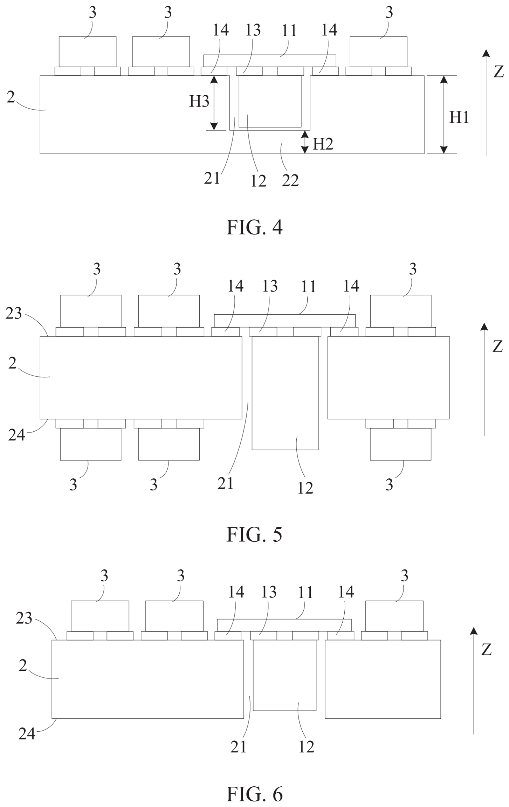

Refer to FIG. 2. An accommodation portion 21 is disposed in the second substrate 2, a surface that is on the first substrate 11 and that is connected to the first body 12 is bridged to two ends of the accommodation portion 21, and at least a part of the first body 12 extends into the accommodation portion 21. The accommodation portion 21 may be formed by reducing a material of a part of the second substrate 2. In an embodiment, FIG. 4 is a diagram of a board-level structure according to Embodiment 2 of this application. Refer to FIG. 4. The accommodation portion 21 may be understood as an inward-recessed structure formed after a part of the second substrate 2 is recessed from one side of the second substrate 2 to the other side, for example, a blind slot. In an embodiment, as shown in FIG. 2, the accommodation portion 21 may also be understood as a through slot disposed in the first substrate 11. In other words, regardless of whether the accommodation portion 21 is specifically a blind slot or a through slot, space used to accommodate the first body 12 can be provided, so that at least a part of the first body 12 can be disposed in the accommodation portion 21, to offset a part of a Z-direction height of the first body 12, and reduce occupation of Z-direction space of an outer side of the second substrate 2 by the first body 12, thereby facilitating a thin design of the electronic device.

In addition, in this embodiment, the first substrate 11 may be connected to a surface that is of the second substrate 2 and that is located at any end of the accommodation portion 21. Therefore, a pad may be formed on the surface of the second substrate 2 at a time by using a stencil printing process, so that the first substrate 11 is bridged above the accommodation portion 21. "Above" refers to a position that is on the outer side of the second substrate 2 and that can be opposite to the accommodation portion 21. For example, the first substrate 11 may be connected to a surface of the second substrate 2, and an edge of the first substrate 11 can be lapped over the second substrate 2 around the accommodation portion 21, without extending into the accommodation portion 21. The accommodation portion 21 is only configured to accommodate the first body 12, and is not configured to solder the first body 12. Therefore, a pad does not need to be separately disposed in the accommodation portion 21. Therefore, when the first component 1 provided in this embodiment and the second substrate 2 are assembled into a board-level structure, an assembly process can be greatly simplified, and assembly quality can be ensured.

More other components may also be connected to the second substrate 2. For ease of description, a component with a small height that is connected to the second substrate 2 may be defined as a second component 3. One or more second components 3 may be disposed. The second components 3 may be disposed on one side of the second substrate 2 in a thickness direction Z, or may be disposed on two sides of the second substrate 2. A height of the first component 1 is greater than a height of the second component 3. In an embodiment, the first substrate 11 and the second component 3 may be fastened to a surface on a same side of the second substrate 2. Protruding directions of the first component 1 and the second component 3 are opposite. The second component 3 protrudes towards an outer side of the second substrate 2, to form a "face-up mounting" form, and the first body 12 protrudes towards an inner side of the second substrate 2, to form a "flip-component mounting" form, to extend into the accommodation portion 21. The accommodation portion 21 offsets a height of the first component 1, to reduce occupation of Z-direction space outside the second substrate 2 by the first component 1. A pad for connecting the first substrate 11 and the second component 3 may be formed at a time on the surface of the second substrate 2 by using a stencil printing process, so that the first substrate 11 and the second component 3 can be connected to the second substrate 2 in a same process flow, thereby simplifying the process and ensuring assembly quality of the first substrate 11 and the second component 3 on the second substrate 2.

In an embodiment, FIG. 5 is a diagram of a board-level structure according to Embodiment 3 of this application. As shown in FIG. 5, the second substrate 2 has a first surface 23 and a second surface 24 on two sides in the thickness direction Z. In an embodiment, both the first surface 23 and the second surface 24 are planes. The board-level structure further includes at least one second component 3, and the second component 3 is connected to the first surface 23 and/or the second surface 24. For example, the plurality of second components 3 may all be connected to the first surface 23, or may all be connected to the second surface 24, or some second components 3 may be connected to the first surface 23, and the other second components 3 are connected to the second surface 24. The first substrate 11 is connected to the first surface 23 and/or the second surface 24. For example, a plurality of first substrates 11 may all be connected to the first surface 23, or may all be connected to the second surface 24, or some first substrates 11 may be connected to the first surface 23, and the other first substrates 11 are connected to the second surface 24. Therefore, assembly between the first component 1, the second component 3, and the second substrate 2 provided in embodiments of this application is flexible, and may be specifically arranged according to an actual mounting condition.

In an embodiment, as shown in FIG. 5, the first substrate 11 is connected to the first surface 23, and at least a part of the second component 3 is connected to the second surface 24. In the thickness direction Z of the board-level structure, a height of the first body 12 is less than or equal to a sum of a thickness of the second substrate 2 and a height of the second component 3. In an embodiment, the accommodation portion 21 is a through slot, and when a height of the first body 12 is greater than a thickness of the second substrate 2 and less than a sum of the thickness of the second substrate 2 and the height of the second component 3, the first body 12 is inserted into the through slot from a side of the first surface 23 of the second substrate 2, and can penetrate from the through slot from a side of the second surface 24 of the second substrate 2. Because the height of the first body 12 is less than or equal to the sum of the thickness of the second substrate 2 and the height of the second component 3, a part of the first body 12 that penetrates from the through slot does not protrude from an end of the second component 3 connected to the second surface 24. Therefore, the second substrate 2 and the second component 3 can offset the overall height of the first body 12 together. In this way, additional Z-direction space cannot be occupied by the first body 12.

In an embodiment, FIG. 6 is a diagram of a board-level structure according to Embodiment 4 of this application. Refer to FIG. 6. Both the first substrate 11 and the second component 3 are connected to the first surface 23 or the second surface 24, and in the thickness direction Z of the board-level structure, a height of the first body 12 is less than or equal to a thickness of the second substrate 2. For example, the accommodation portion 21 is a through slot, both the first substrate 11 and the second component 3 are connected to the first surface 23, and the second component 3 is not disposed on the second surface 24. When a height of the first body 12 is less than or equal to a thickness of the second substrate 2, the thickness of the second substrate 2 may completely offset the height of the first body 12, and one end of the first body 12 away from the first substrate 11 does not extend from a side of the second surface 24 of the second substrate 2. In this way, additional Z-direction space cannot be occupied by the first body 12.

In an embodiment, the first body 12 may not be in contact with the second substrate 2. When the board-level structure is vibrated, vibration of the second substrate 2 may be first transferred to the first substrate 11, and then transferred by the first substrate 11 to the first body 12. In other words, the vibration of the second substrate 2 is not directly transferred to the first body 12, but may be first buffered through the first substrate 11 to reduce impact of vibration, so that vibration on the first body 12 is greatly reduced. Therefore, a good buffering effect is provided to the first body 12 that is sensitive to stress or vibration. In addition, heat from the second substrate 2 is not directly transferred to the first body 12, but may be first transferred to the first substrate 11, and heat is dissipated through the first substrate 11, so that heat transferred to the body can be greatly reduced. This provides a positive benefit for the temperature-sensitive first body 12.

In some other embodiments, the second component 3 with a small height may also cooperate with the accommodation portion 21 in the second substrate 2, to offset the height of the second component 3 using the accommodation portion 21, thereby releasing external space of the second substrate 2 and improving integration.

In an embodiment, as shown in FIG. 2, for heat transfer between the second substrate 2, the first substrate 11, and the first body 12, the first solder joint 13 and the second solder joint 14 are disposed, and a heat transfer path for the second substrate 2 is sequentially as follows: the second substrate 2, the second solder joint 14, the first substrate 11, the first solder joint 13, and the first body 12. A part of the first body 12 in the accommodation portion 21 is not in contact with an inner wall of the accommodation portion 21, that is, the first body 12 is not in contact with the second substrate 2. Therefore, heat of the second substrate 2 is not directly transferred to the first body 12, but may be first transferred to the second solder joint 14, the first substrate 11, and the first solder joint 13 in sequence, and heat is dissipated through the second solder joint 14, the first substrate 11, and the first solder joint 13. The first substrate 11 has a larger area relative to the solder joint, and can dissipate most heat. In this way, heat transferred to the first body 12 can be greatly reduced, and this provides a positive benefit for the temperature-sensitive first body 12.

In addition, the first solder joint 13 and the second solder joint 14 are disposed, so that vibration can be first buffered between the second solder joint 14, the first substrate 11, and the first solder joint 13 when the entire board-level structure is subject to large vibration, to reduce vibration transferred to the first body 12. This provides a buffering effect for the first body 12 that is sensitive to stress or vibration, and reduces impact of vibration.

In an embodiment, the first substrate 11 and the first body 12 may be manufactured into an independent component product, that is, the first component 1. The first component 1 may be integrally fastened to the second substrate 2 through the first substrate 11, and can be soldered to the second substrate 2 by using a same process flow with another second component 3, thereby simplifying a soldering process flow.

In an embodiment, as described above, the accommodation portion 21 may be a blind slot. For a blind slot that has a requirement for soldering a component on an existing circuit board, the component needs to be soldered at a bottom of the blind slot, and is supported by a physical material 22 at the bottom of the blind slot. To ensure reliability of supporting the component, the physical material 22 at the bottom of the blind slot needs to have a specific thickness. Usually, the thickness of this part needs to be greater than 30% of the thickness of the second substrate 2. Therefore, a depth of the blind slot cannot be excessively large, and an offset for the component height is very limited. The blind slot in the second substrate 2 in this application is not used to support a component, and does not have a soldering requirement, and is only used to provide space for accommodating the first body 12. In other words, in a formation process of the second substrate 2, the blind slot may be formed together. Therefore, there is no need to consider support strength of the physical material 22 at the bottom of the blind slot for the component, the depth of the blind slot may be expanded, and the thickness of the physical material 22 at the bottom of the blind slot may be smaller. In an embodiment, as shown in FIG. 4, a ratio of a thickness H3 of the physical material 22 at the bottom of the blind slot to a thickness H1 of the second substrate 2 is less than 3/10. In other words, the thickness H2 of the physical material 22 at the bottom of the blind slot does not need to be greater than 30% of the thickness H1 of the second substrate 2, and may be further reduced, so that space of the blind slot is further expanded, to offset more of the height of the first body 12. For example, as shown in FIG. 4, the thickness H1 of the second substrate 2 may range from 0.5 mm to 1.0 mm, and the thickness H1 of the physical material 22 at the bottom of the blind slot is less than 0.3 mm. A thickness value of the second substrate may be 0.5 mm, 0.6 mm, 1.0 mm, or the like. Correspondingly, if the bottom of the blind slot needs to support a component, the thickness of the bottom of the blind slot needs to be greater than 0.3 mm to ensure support strength. However, in this embodiment, the first body does not need support from the bottom of the blind slot, and the thickness of the bottom of the blind slot may be further reduced to a range less than 0.3 mm, so that space of the blind slot may be further expanded, to offset more of the height of the first body.

In an embodiment, as shown in FIG. 2, as described above, the accommodation portion 21 may alternatively be a through slot, and the through slot penetrates the second substrate 2 in the thickness direction Z of the board-level structure. In other words, when the height of the first body 12 is greater than or equal to the thickness of the second substrate 2, a height value of the first body 12 offset by the through slot is equal to the thickness of the second substrate 2, so that the height of the first body 12 offset by the second substrate 2 can be maximized. However, for the foregoing blind slot having the soldering component to be supported, to provide support for the component, a physical part at the bottom of the blind slot cannot be penetrated, and cannot be designed as the through slot in the second substrate 2 in this application. Therefore, the physical part at the bottom of the blind slot having the soldering component to be supported imposes a limitation on a height offset for the first body 12. However, in this application, the through slot in the second substrate 2 can maximize the height offset for the first body 12.

In an embodiment, there is a gap between the inner wall of the accommodation portion 21 and the first body 12. When the first body 12 is assembled to the second substrate 2, the first body 12 may be first soldered to the first substrate 11, then the first body 12 is inserted into the accommodation portion 21 in the second substrate 2, and the first substrate 11 is soldered to the second substrate 2. The gap exists between the inner wall of the accommodation portion 21 and the first body 12, so that a mounting tolerance of the first body 12 can be offset by the gap. This ensures that the first body 12 can be normally mounted in the accommodation portion 21 without interference or friction against the inner wall of the accommodation portion 21, to avoid mounting failure and surface wear-out of the first body 12. In addition, vibration and heat from the second substrate 2 cannot be directly transferred to the first body 12, thereby reducing impact of the vibration and heat on the first body 12.

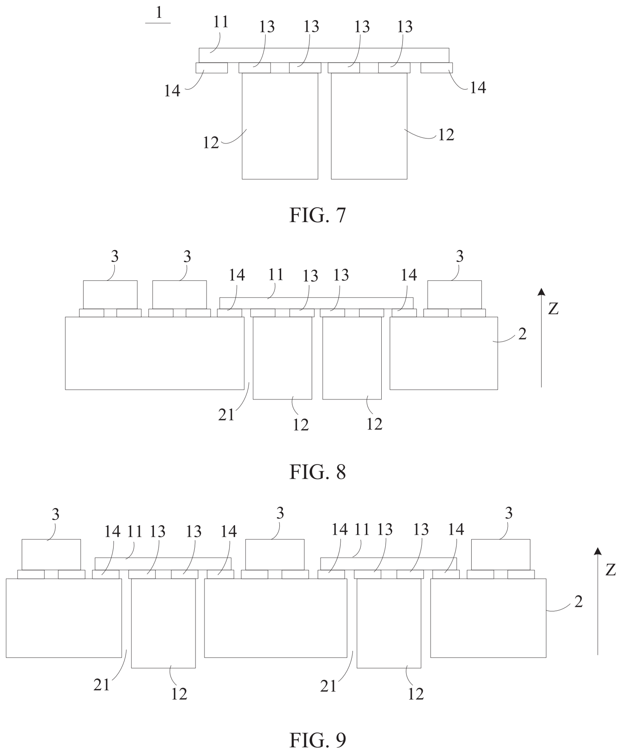

In an embodiment, FIG. 7 is a diagram of a structure of a first component 1 according to another embodiment of this application. FIG. 8 is a diagram of a board-level structure according to Embodiment 5 of this application. As shown in FIG. 7 and FIG. 8, a plurality of first bodies 12 may be disposed, and the plurality of first bodies 12 are distributed at intervals on one first substrate 11. There may be two, three, or more first bodies 12. Each first body 12 may be fastened to a same first substrate 11, so that the first substrate 11 and the plurality of first bodies 12 form a component as a whole. Then, the whole component may be fastened and assembled by connecting the first substrate 11 to the second substrate 2. This facilitates process processing. In an embodiment, as shown in FIG. 8, there may be one accommodation portion 21 in the second substrate 2, so that the accommodation portion 21 can simultaneously accommodate a plurality of first bodies 12. In an embodiment, there may be a plurality of accommodation portions 21 in the second substrate 2, and each accommodation portion 21 may correspondingly accommodate one first body 12. In some other embodiments, as shown in FIG. 2, only one first body 12 may be disposed.

In an embodiment, FIG. 9 is a diagram of a board-level structure according to Embodiment 6 of this application. As shown in FIG. 9, a plurality of first bodies 12 and a plurality of first substrates 11 may be disposed, and one first substrate 11 is connected to one corresponding first body 12. In other words, one first body 12 and one first substrate 11 may form one component. There may be a plurality of such components, and the components can be separately connected to the second substrate 2. The components may be arranged adjacently, or may be arranged in a staggered manner with the second component 3. In addition, both a first substrate 11 connected to a plurality of first bodies 12 and a first substrate 11 connected to only one first body 12 may be assembled on the second substrate 2. Specifically, configuration may be selectively implemented according to an actual application condition.

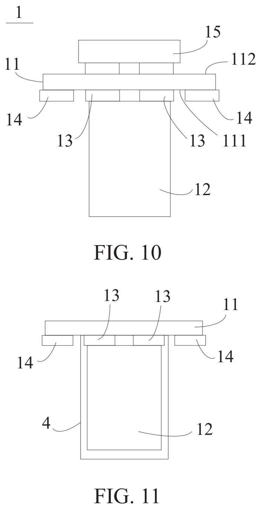

In an embodiment, FIG. 10 is a diagram of a structure of a first component 1 according to still another embodiment of this application. As shown in FIG. 10, the board-level structure further includes a second body 15, and the second body 15 is disposed on the second surface 112 of the first substrate 11. In other words, the first body 12 and the second body 15 are respectively connected to two opposite sides of the first substrate 11. The first substrate 11 provides more positions for connections of bodies that can implement different functions, so that more functional components are disposed on the second substrate 2, thereby improving integration, saving space, and facilitating miniaturization of the electronic device.

A height of the second body 15 is less than a height of the first body 12 in the thickness direction Z of the board-level structure. The first body 12 with the larger height is disposed on a side that is of the first substrate 11 and that faces the second substrate 2, and the height of the first body 12 may be offset by the accommodation portion 21 of the second substrate 2, thereby reducing occupation of space outside the second substrate 2. The second body 15 with the smaller height is disposed on a side that is of the first substrate 11 and that is away from the second substrate 2, to form the foregoing mounting form of "face-up mounting". The height of the second body 15 is equivalent to a height of a component like another second component 3, so that space above the first substrate 11 can be fully used, and an overall height of the board-level structure is not limited.

In an embodiment, FIG. 11 is a diagram of a structure of a first component 1 according to yet another embodiment of this application. As shown in FIG. 11, the board-level structure further includes a package 4, and the package 4 fixedly encapsulates the first body 12. The package 4 may be made of an epoxy resin or silicone material. After the first body 12 is soldered to the first substrate 11 through the first solder joint 13, the package 4 may fixedly encapsulate a surface of the first component 1, and the first solder joint 13 may also be encapsulated by the package 4, so that the first body 12 and the first solder joint 13 can be protected, and impurities and water vapor in an environment cannot erode the first body 12 and the first solder joint 13.

The foregoing descriptions are merely preferred embodiments of this application and are not intended to limit this application. For a person skilled in the art, this application may have various modifications and changes. Any modification, equivalent replacement, or improvement made without departing from the spirit and principle of this application shall fall within the protection scope of this application.

## Claims

1. A board-level structure, comprising:
at least one first component, wherein the first component comprises a first body and a first substrate, a first solder joint and a second solder joint are disposed on the first substrate, and the first substrate is connected to the first body through the first solder joint; and
a second substrate, wherein the second substrate comprises an accommodation portion and a third solder joint, the third solder joint is located on the second substrate and is close to the accommodation portion, the first substrate is soldered to the second substrate through the second solder joint and the third solder joint, the first substrate is bridged above the accommodation portion, and at least a part of the first body extends into the accommodation portion.

2. The board-level structure according to claim 1, wherein the accommodation portion is a through slot, and the through slot penetrates the second substrate in a thickness direction of the board-level structure.

3. The board-level structure according to claim 1 or 2, wherein there is a gap between an inner wall of the accommodation portion and the first body.

4. The board-level structure according to claim 2 or 3, wherein the second substrate has a first surface and a second surface on two sides in the thickness direction;
the board-level structure further comprises at least one second component, wherein the second component is connected to the first surface and/or the second surface; and
the first substrate is connected to the first surface and/or the second surface.

5. The board-level structure according to claim 4, wherein the first substrate is connected to the first surface, at least a part of the second component is connected to the second surface, and in the thickness direction of the board-level structure, a height of the first body is less than or equal to a sum of a thickness of the second substrate and a height of the second component.

6. The board-level structure according to claim 4, wherein both the first substrate and the second component are connected to the first surface or the second surface, and in the thickness direction of the board-level structure, a height of the first body is less than or equal to a thickness of the second substrate.

7. The board-level structure according to claim 1, wherein the accommodation portion is a blind slot.

8. The board-level structure according to claim 7, wherein a ratio of a thickness of a bottom of the blind slot to a thickness of the second substrate is less than 3/10.

9. The board-level structure according to claim 8, wherein a thickness value of the second substrate ranges from 0.5 mm to 1.0 mm.

10. The board-level structure according to claim 7, wherein a thickness of a bottom of the blind slot is less than 0.3 mm.

11. The board-level structure according to any one of claims 1 to 10, wherein the second substrate is a printed circuit board.

12. A first component, wherein the first component comprises:
a first body; and
a first substrate, wherein the first substrate comprises a first surface and a second surface that are disposed opposite to each other; a first solder joint and a second solder joint are disposed on the first surface, the first substrate is connected to the first body through the first solder joint, and the second solder joint is configured to connect to a second substrate; and an accommodation portion is disposed in the second substrate, and at least a part of the first body extends into the accommodation portion.

13. The first component according to claim 12, wherein a plurality of first bodies are disposed, and all the plurality of first bodies are connected to the first substrate.

14. The first component according to claim 12 or 13, further comprising a second body, wherein the second body is disposed on the second surface.

15. The first component according to claim 14, wherein in a thickness direction of the first component, a height of the second body is less than a height of the first body.

16. The first component according to any one of claims 12 to 15, further comprising a package, wherein the package encapsulates the first body.

17. The first component according to any one of claims 12 to 16, wherein the first substrate is a printed circuit board.

18. An electronic device, comprising the board-level structure according to any one of claims 1 to 11.
